# EUROPEAN PATENT APPLICATION

(11) **EP 4 746 623 A1**
(43) Date of publication of application: **20.05.2026**
(21) Application number: 25216958.6
(22) Date of filing: 19.11.2025
(51) Int. Cl.: H10B 80/00, H10D 80/00, H10W 44/00, H10W 40/25, H10W 70/00, H10W 70/60

(54) **PACKAGE STRUCTURE FOR A SEMICONDUCTOR DEVICE**

(30) Priority: 19.11.2024 NL 2039111
(71) Applicant: Nexperia B.V., 6534 AB Nijmegen (NL)
(72) Inventor: Gong, Wei, Manchester (GB); Simpson, Robin, Manchester (GB); Cao, Pulong, Shanghai (CN)
(74) Representative: Pjanovic, Ilija

(57) **Abstract**

What is disclosed is a package structure for a semiconductor device comprising: a substrate layer configured for thermal management and electrical insulation; one or more semiconductor dies on the substrate layer, each semiconductor die comprising: a first power contact configured to connect to a first terminal of the package, a second power contact configured to connect to a second terminal of the package, and a gate contact configured to connect to a gate terminal of the package; an integrated resistor structure disposed within the substrate layer.

## Description

### TECHNICAL FIELD

The present disclosure generally relates to the field of power semiconductor devices, and more particularly to the field of package structures for semiconductor devices as well as a method for manufacturing a such devices.

### BACKGROUND OF THE DISCLOSURE

In power electronics, semiconductor devices such as Insulated Gate Bipolar Transistor (SGBT) and wide-bandgap (WBG) semiconductor devices like silicon carbide (SiC) and gallium nitride (GaN) components are increasingly used in applications requiring high efficiency, high switching speeds, and elevated thermal performance. These devices operate at higher voltages, currents, and frequencies than traditional silicon-based devices, making them suitable for demanding applications like electric vehicles, industrial power systems, and renewable energy inverters. However, the high power density and thermal demands of WBG devices require efficient thermal management and precise electrical control within the package structure to ensure stable operation and long-term reliability.

Typically, power semiconductor devices are mounted on substrates designed to provide thermal dissipation, electrical insulation, and mechanical support. These substrates often employ direct-bonded copper (DBC) or active metal brazed (AMB) layers bonded to a ceramic core, which offers good thermal conductivity and electrical insulation. Electrical connections to the dies are achieved through bonding wires or metal contacts, and external control and power contacts are added to complete the circuit. Despite these advancements, challenges remain, particularly in managing oscillations and ensuring balanced current sharing between dies in parallel configurations. In traditional designs, discrete resistors are added in control loops to balance current and mitigate oscillations; however, these components add to the package size and complicate the substrate layout.

The conventional use of discrete resistors within the control loops of WBG power modules has several disadvantages. First, the physical presence of these resistors on the substrate increases the required space, limiting design flexibility and potentially impeding thermal performance. Second, the fixed values of these resistors constrain their adaptability to varying operating conditions, often necessitating additional external circuitry to fine-tune performance parameters. Moreover, the presence of discrete components can create complex parasitic inductances within the circuit, impacting switching efficiency and increasing the risk of resonant oscillations that could lead to unwanted thermal hotspots and reliability issues.

It is therefore a goal of the present invention to provide an improved package structure for WBG semiconductor devices that offers flexibility in resistance, shape, and dimensions, allowing for an optimized layout that enhances thermal management and minimizes parasitic inductances.

### SUMMARY OF THE DISCLOSURE

A first aspect of the present disclosure relates to package structure for a semiconductor device, comprising:
a substrate layer configured for thermal management and electrical insulation;
one or more semiconductor dies on the substrate layer, each semiconductor die comprising:
   a first power contact configured to connect to a first terminal of the package,
   a second power contact configured to connect to a second terminal of the package, and
   a gate contact configured to connect to a gate terminal of the package;
an integrated resistor structure disposed within the substrate layer.

In the second aspect a method is provided for manufacturing a package structure for a semiconductor device, the method comprising:
forming a substrate layer configured for thermal management and electrical insulation;
placing one or more semiconductor dies on the substrate layer, each semiconductor die comprising:
   a first power contact configured to connect to a first terminal of the package,
   a second power contact configured to connect to a second terminal of the package, and
   a gate contact configured to connect to a gate terminal of the package;
configuring an integrated resistor structure within the substrate layer, the integrated resistor structure being arranged to balance current sharing and mitigate oscillations in the device.

One aspect of the present invention relates to a package structure for a semiconductor device. In an example, the semiconductor device may be a wide-bandgap (WBG) semiconductor device, or a Insulated Gate Bipolar Transistor (IGBT) semiconductor device. A package structure may be understood as an assembly that provides mechanical support, electrical connections, and thermal management for semiconductor components. Wide-bandgap semiconductor devices typically incorporate materials such as silicon carbide (SiC) or gallium nitride (GaN), which enable efficient operation at higher voltages, temperatures, and switching frequencies compared to traditional silicon-based devices. These properties make semiconductor devices suitable for high-power applications, where effective thermal dissipation and stable operation under demanding conditions are required.

The package structure comprises a substrate layer configured for thermal management and electrical insulation. A substrate layer may include materials with high thermal conductivity, such as direct-bonded copper (DBC) or active metal brazed (AMB) structures, bonded to a ceramic core. This configuration allows heat generated by the semiconductor device to be spread and dissipated efficiently, ensuring thermal stability and enhancing the operational reliability of the device under high power densities. An effect of this arrangement is extended device lifespan and consistent performance, addressing the thermal challenges inherent in for example WBG or IGBT applications.

The package structure also includes one or more semiconductor dies positioned on the substrate layer, each semiconductor die comprising a first power contact, a second power contact, and a gate contact. A semiconductor die may be understood as the core active element within the device, which can perform switching or rectification functions. The first power contact is configured to connect to a first terminal of the package, which may function as a source or emitter terminal, while the second power contact connects to a second terminal, such as a drain or collector terminal. The gate contact connects to a gate terminal of the package, facilitating control over the die's switching behavior. This arrangement allows for effective current flow and control within each die, supporting high-current applications by ensuring stable power delivery and precise switching.

An integrated resistor structure is disposed within the substrate layer, and may be configured to balance current sharing and mitigate oscillations within the device. The term "integrated resistor" refers to a resistive component embedded directly in the substrate layer, eliminating the need for discrete resistor elements. Integration may involve various techniques, including deposition, coating, injecting, or printing resistive material directly onto patterned regions of the substrate. This integrated resistor may be positioned along the gate line, source line, or both, providing flexibility in design. An effect of this configuration is reduced space requirements and minimized parasitic inductance, as the resistor structure is in close proximity to the semiconductor dies. Such seamless or direct integration can be explained as that it is not a layer that is placed on top of the Active Metal Brazed structures or Direct Bonded Copper layer, and as such, it supports compact and efficient designs, enhancing device stability by balancing current distribution and controlling oscillations, particularly in multi-die configurations. In an example wherein the integrated resistor is configured as an integrated Kelvin source resistor, such configuration restrains the circulating current among the Kelvin source, parallel chips, and power source in a closed loop circuit, which may affect the control signals and dynamic performance. In general, the integrated resistor improves the overall package dynamic performance and thus not only balances current sharing and mitigates oscillations.

In an example, the device comprises two or more semiconductor dies on the substrate layer, more particularly, there may be two semiconductor dies, or even three, four or more semiconductor dies.

The semiconductor device may, in an example be any of an Insulated Gate Bipolar Transistor (IGBT) or Wide Band Gap (WBG) semiconductor device.

In an example, the package structure for the semiconductor device comprises an integrated resistor structure disposed between the gate terminal and the gate contact of each semiconductor die. It may be provided that the integrated resistor positioned in this way enables precise control of gate signals, as the resistor can dampen oscillations that might otherwise arise during high-speed switching. An effect of this configuration is improved stability and synchronization in the control of multiple dies, enhancing overall device performance by reducing signal noise in the gate path.

In an example, the package structure for the semiconductor device further comprises a sense terminal, wherein the integrated resistor structure is configured as a Kelvin source resistor disposed between the first power contact of each semiconductor die and the sense terminal. It may be provided that positioning the resistor as a Kelvin source resistor enables accurate current measurement by minimizing voltage drops from other potential influences in the circuit. This configuration provides more reliable current sensing and balancing across multiple dies, promoting stable operation and allowing effective current control in high-power applications.

In an example the integrated resistor structure disposed within the substrate layer comprises at least two resistors. There may be two resistors, three, four, five, six, or more, and preferably an even number. This configuration provides improved design flexibility, allowing the distribution of resistance across multiple paths within the substrate. By employing multiple resistors, the package can better manage current distribution across semiconductor dies, enhancing the device's overall stability and reliability.

In an example, each of the at least two resistors within the substrate layer has the same resistance value. This uniformity in resistance ensures consistent electrical behavior across multiple current paths, minimizing imbalances that could otherwise lead to oscillations or uneven current sharing. Such symmetry in resistor values is beneficial for parallel die configurations, where balanced current flow is critical for maintaining stable performance.

In an example, at least a first of the two resistors is disposed between the gate terminal and the gate contact of each semiconductor die, while a second resistor is configured as a Kelvin source resistor, positioned between the first power contact of each semiconductor die and the sense terminal. This dual-resistor setup, or dual-resistor structure, wherein each structure having two or more resistors, enables precise current balancing and oscillation mitigation. The resistor between the gate terminal and gate contact helps stabilize gate signals during high-speed switching, while the Kelvin source resistor ensures accurate current sensing and control. Together, these resistors promote smooth, synchronized operation across semiconductor dies, supporting the package structure's suitability for high-power and high-frequency applications.

In another example, the first and second resistors are configured with the same resistance value. This equality in resistance enhances the consistency of current regulation and reduces potential for parasitic effects, thereby improving device performance under demanding operational conditions. By maintaining equivalent resistance values, the package structure minimizes discrepancies in current flow and voltage drops, ensuring reliable operation and effective thermal management in multi-die configurations.

In an example, the package structure for the semiconductor device has the integrated resistor structure configured to provide flexibility in dimensions, shape, and resistance values for optimized layout and thermal performance. It may be provided that such flexibility allows customization to suit specific application needs, enhancing the adaptability of the resistor structure to varying operational conditions. An effect of this feature is the ability to optimize space within the package while achieving effective thermal management, which supports higher power densities without compromising device integrity.

In an example, the package structure for the semiconductor device has the resistive material of the integrated resistor structure comprising at least one of nichrome, manganin, constantan, tungsten, graphite, tin oxide, aluminum oxide, manganese oxide, tantalum, chromium, tantalum nitride, silver palladium, ruthenium oxide, polymer, silicon, germanium, or ceramic material. It may be provided that using these materials allows for improved thermal and electrical performance under high-power conditions, as each material offers unique conductive and thermal properties. This configuration enhances the durability and efficiency of the resistor, reducing thermal buildup and ensuring stable operation.

In an example, the package structure for the semiconductor device has the integrated resistor structure formed by depositing, coating, injecting, or printing the resistive material on a patterned region within the substrate layer. It may be provided that these manufacturing techniques allow for precise control of the resistor's placement and shape, facilitating customized designs to match specific electrical characteristics. An effect of this feature is an efficient use of substrate surface area, which supports high-density device packaging without sacrificing performance.

In an example, the package structure for the semiconductor device has the substrate layer comprising a direct-bonded copper (DBC) or active metal brazed (AMB) structure for enhanced thermal conductivity and electrical insulation. It may be provided that these substrate structures allow heat generated by the semiconductor dies to be dissipated efficiently, maintaining thermal stability across the device. This configuration improves the operational lifespan and reliability of the WBG device under high power densities, as it effectively manages heat.

In an example, the package structure for the semiconductor device has a conductive trace disposed on the substrate layer between the first power contact of each semiconductor die and the first terminal of the package. It may be provided that this conductive trace facilitates the direct transfer of current from the power contact to the terminal, ensuring stable and low-resistance power distribution. This arrangement minimizes resistive losses and contributes to efficient current flow, supporting the performance requirements of high-current applications.

In an example, the package structure for the semiconductor device has a gate control conductive trace disposed on the substrate layer between the gate contact of each semiconductor die and the gate terminal of the package. It may be provided that this gate control trace enables precise delivery of control signals to the gate, ensuring that each semiconductor die receives synchronized and stable gate signals. An effect of this feature is enhanced switching performance, as it reduces signal delays and supports high-speed operation in multi-die configurations.

In an example, the package structure for the semiconductor device has the conductive trace or gate control conductive trace connected to each contact via a bonding component. It may be provided that the bonding component, which could be a wire bond or copper clip, offers reliable mechanical and electrical connections, accommodating thermal expansion and maintaining stable performance. An effect of this feature is improved durability under thermal stress, which helps prevent connection failures and supports the long-term reliability of the package structure.

In an example, the package structure for the semiconductor device has the integrated resistor structure contained within the conductive trace. It may be provided that embedding the resistor within the conductive trace minimizes additional components in the design, leading to a more compact and efficient layout. This configuration reduces parasitic inductance and helps maintain a stable current flow, enhancing device performance in high-frequency switching applications.

In an example, the package structure for the semiconductor device further comprises a Kelvin conductive trace disposed on the substrate layer, wherein the gate control conductive trace is enclosed by the Kelvin conductive trace, or the Kelvin conductive trace is enclosed by the gate control conductive trace. It may be provided that this configuration of enclosing one trace within another minimizes electromagnetic interference between the traces, which is critical in maintaining signal integrity. This arrangement improves control signal accuracy, supporting stable and synchronized operation in multi-die power modules.

In an example, the package structure for the semiconductor device has each semiconductor die further comprising a Kelvin connection pad, with the gate and the Kelvin connection pad of each semiconductor die connected to the gate control conductive trace and the Kelvin conductive trace, respectively. It may be provided that this configuration enables precise voltage measurement at the source of the die, ensuring accurate control and minimizing losses due to voltage drops. This arrangement supports balanced current distribution and stable operation, particularly beneficial in high-power and high-precision applications.

In an example, the package structure for the semiconductor device has the bonding component connecting each semiconductor die to the gate control conductive trace comprising a bonding wire or a copper clip. It may be provided that these bonding components offer flexible and robust connections, adapting to thermal expansion while maintaining strong electrical contacts. An effect of this feature is enhanced durability in thermally demanding environments, ensuring long-term reliability of the electrical connections within the package.

In an example, the package structure for the semiconductor device further comprises a temperature sensor disposed on the substrate layer, with the temperature sensor and the semiconductor die located on the same layer. It may be provided that positioning the temperature sensor in proximity to the semiconductor die allows for real-time monitoring of the device's thermal conditions. This configuration enables proactive thermal management, allowing dynamic adjustments to prevent overheating and maintain optimal operating conditions.

In an example, the package structure for the semiconductor device has each semiconductor die comprising an IGBT die, SiC die, SI MOSFET, or GaN die. It may be provided that these types of semiconductor dies are optimized for high-efficiency power conversion, particularly in high-voltage and high-frequency applications. This configuration enables improved power density and efficiency, making the device suitable for advanced power electronics applications that demand robust performance under extreme conditions.

In an example, the package structure for the semiconductor device has each of the first power contacts and second power contacts of the semiconductor dies connected to the substrate through a bonding wire or a metal contact. It may be provided that using bonding wires or metal contacts for these connections ensures strong electrical pathways that support high-current applications. This configuration minimizes resistance at contact points, enhancing current flow and contributing to the overall efficiency of the device.

In an example, the package structure for the semiconductor device has a Kelvin contact disposed on the substrate as an integral component with the second power contact. It may be provided that integrating the Kelvin contact with the second power contact simplifies the substrate design, reducing the need for additional components. This configuration allows for more compact and efficient layouts, enhancing the performance of the device by minimizing parasitic effects and reducing assembly complexity.

In an example, the package structure for the semiconductor device has the gate control conductive trace located between each semiconductor die and the Kelvin conductive trace, or the Kelvin conductive trace is located between each semiconductor die and the gate control conductive trace. It may be provided that this arrangement minimizes crosstalk and interference between the control and Kelvin traces, preserving the integrity of control signals. This configuration enhances switching performance by maintaining clean signal pathways, which is essential in high-speed and high-precision applications.

In an example, the package structure for the semiconductor device has the connection mode of the second power contact of each semiconductor die to the substrate comprising either a bonding wire connection or a metal contact. It may be provided that this flexibility in connection mode accommodates different design requirements, allowing for reliable and low-resistance electrical connections tailored to the specific application. This arrangement improves current transfer efficiency, supporting high-power performance with minimal energy loss.

In an example, the package structure for the semiconductor device has the integrated resistor structure configured to mitigate oscillations due to parasitic inductance in the control loop by balancing current sharing between parallel-connected dies. It may be provided that the resistor structure, positioned strategically to counteract parasitic inductance, enhances device stability by reducing resonant effects in the circuit. This configuration ensures consistent performance across parallel dies, contributing to the reliability and efficiency of the semiconductor device under dynamic operating conditions.

### BRIEF DESCRIPTION OF THE DRAWINGS

The disclosure will now be discussed with reference to the drawings, which show in:
Figure 1 illustrates an embodiment of a package structure for a semiconductor device according to a fist aspect of the present disclosure;
Figure 2 illustrates an embodiment of a package structure for a semiconductor device according to a second aspect of the present disclosure.

### DETAILED DESCRIPTION OF THE DISCLOSURE

The present disclosure relates to package structures for semiconductor devices, particularly those incorporating wide-bandgap (WBG) materials such as silicon carbide (SiC) and gallium nitride (GaN), as well as insulated gate bipolar transistors (IGBTs). These package structures are designed to provide efficient thermal management, electrical insulation, and stable control over device performance under high power density conditions.

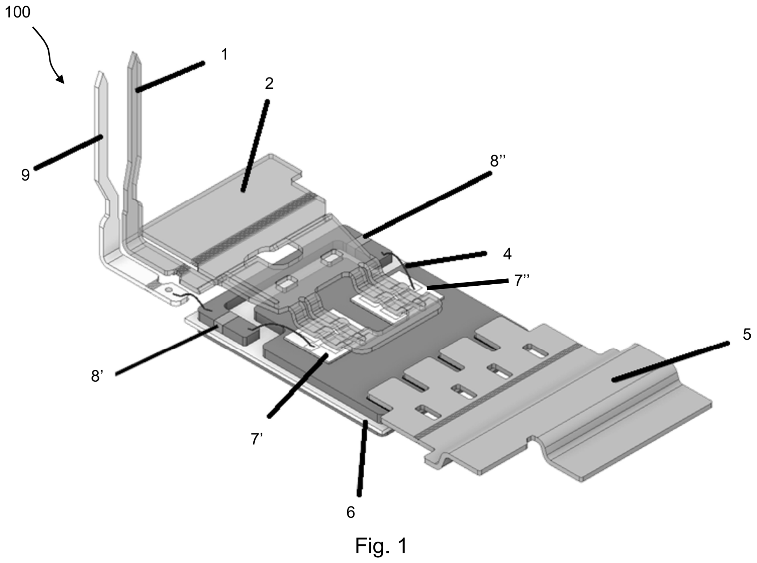

FIG. 1 illustrates an embodiment of a package structure 100 for a semiconductor device, designed to provide a compact and efficient assembly that supports high-power applications. The device includes a substrate layer 6 that serves as the foundation for mounting semiconductor dies 7' and 7" and is configured for effective thermal management and electrical insulation. The substrate layer 6 may include materials such as direct-bonded copper DBC or active metal brazed AMB structures, which are known for their high thermal conductivity and durability.

The package structure includes one or more semiconductor dies 7' and 7" positioned on the substrate layer 6. Each semiconductor die is configured with a first power contact, a second power contact, and a gate contact, respectively connected to a first terminal 2, a second terminal 5, and a gate terminal 9 of the package.

A notable feature in this embodiment is the inclusion of integrated resistor structures 8' and 8" embedded within the substrate layer 6 and disposed between the gate terminal 9 and the gate contact of each semiconductor die. The integration of the resistor structures directly within the substrate layer allows for a more compact package design, as it eliminates the need for discrete resistor components on the substrate. An effect of this configuration is that it minimizes parasitic inductance associated with external resistors, thus improving the stability and reliability of the device during high-speed switching operations. By dampening oscillations within the gate path, the integrated resistor structures enhance device stability, supporting smooth and efficient switching even in high-frequency applications.

Additionally, the substrate layer 6 includes bonding components, such as bonding wires 4, that connect each semiconductor die to the integrated resistor structures. These bonding wires 4 are designed to provide both mechanical and electrical connectivity, accommodating thermal expansion and contraction during operation.

In this embodiment, the package structure 100 with its integrated resistor structures 8' and 8" also supports parallel die configurations by balancing current sharing between the semiconductor dies 7' and 7". By carefully positioning the resistors within the substrate layer, the package ensures that each die receives a balanced current distribution, reducing the risk of thermal hotspots and enhancing the overall efficiency of the device. This feature is advantageous in multi-die configurations, where precise current control is critical for preventing uneven heating and extending the operational life of the device.

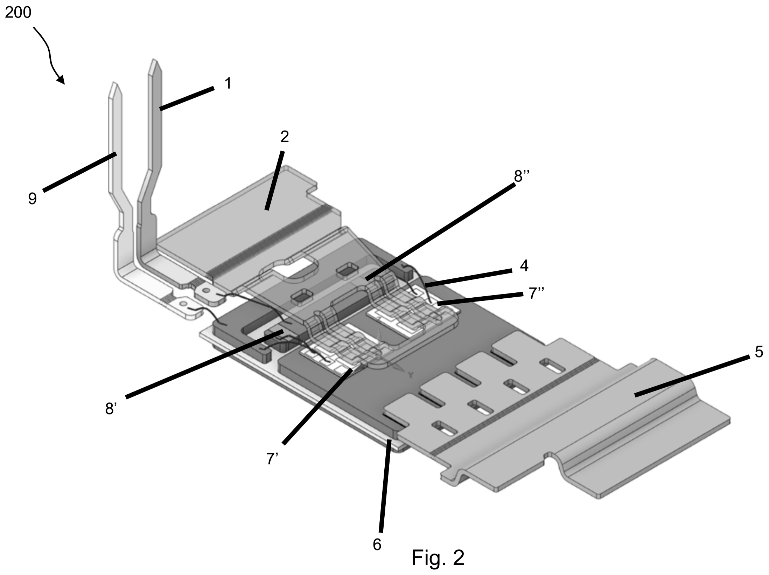

FIG. 2 illustrates a second embodiment of the package structure 200, which incorporates a Kelvin source resistor configuration for enhanced current sensing and control. In this embodiment, the integrated resistor structures 8' and 8" are configured as Kelvin source resistors, located between the first power contact of each semiconductor die 7' and 7" and a sense terminal 1. This configuration is particularly effective for applications requiring accurate current measurement and control, as the Kelvin source resistor arrangement allows for precise voltage sensing directly at the source, free from the interference of the main current path. With this configuration voltage drops are minimized that could otherwise interfere with the control signals, thus providing a more accurate representation of the current conditions within the device.

The use of a Kelvin source resistor in the package structure 200 enables a more reliable and responsive control system by restraining circulating currents within the closed-loop circuit that includes the Kelvin source, parallel chips, and power source. An effect of this feature is improved dynamic performance, as the accurate sensing and control of circulating currents help mitigate the impact of parasitic elements on signal integrity. This configuration is particularly beneficial for high-speed switching applications, where precise control over the current flow is essential for minimizing signal delays and maintaining stability under rapid switching conditions.

The second embodiment also maintains the advantages of effective thermal management provided by the substrate layer 6, which is configured with DBC or AMB structures to dissipate heat efficiently. This structure supports high-power densities by channeling heat away from the semiconductor dies, helping to prevent overheating and ensuring stable operation under continuous load. An effect of this thermal management capability is that it reduces the need for additional cooling mechanisms, making the device more compact and suitable for applications where space is limited but thermal control is critical.

Furthermore, the substrate layer 6 in both embodiments is designed with flexibility in terms of the dimensions, shape, and resistance values of the integrated resistor structures 8' and 8". This flexibility allows for customization based on specific application requirements, optimizing the layout for thermal performance and electrical characteristics. An effect of this customization capability is that it enhances the adaptability of the package structure for various operational conditions, supporting both high-power and high-frequency applications without compromising device integrity.

In addition to the Kelvin source configuration in FIG. 2, the package structure 200 includes the bonding components 4 that connect each semiconductor die to the integrated resistor structures, ensuring reliable connectivity even under thermal expansion.

Both the disclosed package structure of Fig. 1 and Fig. 2 offer a compact, efficient solution for high-power semiconductor devices by integrating resistor structures within the substrate layer, providing improved thermal management, minimized parasitic inductance, and enhanced current control. These features support stable operation under high-switching frequencies and high-current loads, making the device suitable for advanced power electronics applications. Each feature in the design contributes to the technical advantages observed in both embodiments, ensuring reliable and efficient performance under challenging conditions.

### List of Reference Numerals

- 100: Package structure of the first embodiment
- 200: Package structure of the second embodiment
- 1: Sense terminal
- 2: First terminal (source or emitter terminal)
- 4: Bonding wire
- 5: Second terminal (drain or collector terminal)
- 6: Substrate layer (for thermal management and electrical insulation)
- 7', 7": Semiconductor dies
- 8', 8": Integrated resistor structures
- 9: Gate terminal

## Claims

1. A package structure for a semiconductor device (100, 200), comprising:
a substrate layer (6) configured for thermal management and electrical insulation;
one or more semiconductor dies (7', 7") on the substrate layer (6), each semiconductor die comprising:
a first power contact configured to connect to a first terminal (2) of the package,
a second power contact configured to connect to a second terminal (5) of the package, and
a gate contact configured to connect to a gate terminal (9) of the package;
an integrated resistor structure (8', 8") disposed within the substrate layer (6).

2. The package structure for the semiconductor device of claim 1, wherein the device comprises two or more semiconductor dies on the substrate layer.

3. The package structure for the semiconductor device of claim 1, wherein the integrated resistor structure is disposed between the gate terminal and the gate contact of each semiconductor die.

4. The package structure for the semiconductor device of claim 1, further comprising a sense terminal (1), wherein the integrated resistor structure is configured as a Kelvin source resistor disposed between the first power contact of each semiconductor die and the sense terminal (1).

5. The package structure for the semiconductor device of claim 1, wherein the an integrated resistor structure (8', 8") disposed within the substrate layer comprises at least two resistors.

6. The package structure for the semiconductor device of claim 5, wherein each of the at least two resistors have the same resistance value.

7. The package structure for the semiconductor device of claim 3, 4 and 6, wherein at least a first of the two resistors is disposed between the gate terminal and the gate contact of each semiconductor die, and a second of the at least two resistors is configured as a Kelvin source resistor disposed between the first power contact of each semiconductor die and the sense terminal (1).

8. The package structure for the semiconductor device of claim 7, wherein the first and second resistors have the same resistance value.

9. The package structure for the semiconductor device of claim 1, wherein the integrated resistor structure is configured to provide flexibility in dimensions, shape, and resistance values for optimized layout and thermal performance.

10. The package structure for the semiconductor device of claim 1, wherein the resistive material of the integrated resistor structure comprises at least one of nichrome, manganin, constantan, tungsten, graphite, tin oxide, aluminum oxide, manganese oxide, tantalum, chromium, tantalum nitride, silver palladium, ruthenium oxide, polymer, silicon, germanium, or ceramic material.

11. The package structure for the semiconductor device of claim 1, wherein the integrated resistor structure is formed by depositing, coating, injecting, or printing the resistive material on a patterned region within the substrate layer.

12. The package structure for the semiconductor device of claim 1, wherein the substrate layer comprises a direct-bonded copper (DBC) or active metal brazed (AMB) structure for enhanced thermal conductivity and electrical insulation.

13. The package structure for the semiconductor device of claim 1, wherein a conductive trace is disposed on the substrate layer between the first power contact of each semiconductor die and a terminal of the package.

14. The package structure for the semiconductor device of claim 1, wherein a gate control conductive trace is disposed on the substrate layer between the gate contact of each semiconductor die and the gate terminal of the package.

15. The package structure for the semiconductor device of claim 13 or claim 12, wherein the conductive trace or gate control conductive trace is connected to each contact via a bonding component (4).

16. The package structure for the semiconductor device of claim 11 or claim 14, wherein the integrated resistor structure is contained within the conductive trace.

17. The package structure for the semiconductor device of claim 1, further comprising a Kelvin conductive trace disposed on the substrate layer, wherein the gate control conductive trace is enclosed by the Kelvin conductive trace, or the Kelvin conductive trace is enclosed by the gate control conductive trace.

18. The package structure for the semiconductor device of claim 17, wherein each semiconductor die further comprises a Kelvin connection pad, the gate and the Kelvin connection pad of each semiconductor die being connected to the gate control conductive trace and the Kelvin conductive trace, respectively.

19. The package structure for the semiconductor device of claim 1, wherein the bonding component connecting each semiconductor die to the gate control conductive trace comprises a bonding wire or a copper clip.

20. The package structure for the semiconductor device of claim 1, further comprising a temperature sensor disposed on the substrate layer, the temperature sensor and the semiconductor die being located on the same layer.

21. The package structure for the semiconductor device of claim 1, wherein each semiconductor die comprises an IGBT die, SiC die, SI MOSFET or GaN die.

22. The package structure for the semiconductor device of claim 1, wherein each of the first power contacts and second power contacts of the semiconductor dies are connected to the substrate through a bonding wire or a metal contact.

23. The package structure for the semiconductor device of claim 16, wherein the gate control conductive trace is located between each semiconductor die and the Kelvin conductive trace, or the Kelvin conductive trace is located between each semiconductor die and the gate control conductive trace.

24. The package structure for the semiconductor device of claim 1, wherein the connection mode of the second power contact of each semiconductor die to the substrate comprises either a bonding wire connection or a metal contact.

25. A method for manufacturing a package structure for a semiconductor device, the method comprising:
forming a substrate layer configured for thermal management and electrical insulation;
placing one or more semiconductor dies on the substrate layer, each semiconductor die comprising:
a first power contact configured to connect to a first terminal of the package,
a second power contact configured to connect to a second terminal of the package, and
a gate contact configured to connect to a gate terminal of the package;
configuring an integrated resistor structure within the substrate layer.
